# EUROPEAN PATENT SPECIFICATION

(11) **EP 0 564 168 B1**
(45) Date of publication and mention of the grant of the patent: **08.12.1999**
(21) Application number: 93302294.9
(22) Date of filing: 25.03.1993
(51) Int. Cl.: G03C 7/12, G02B 5/22, G03F 7/004

(54) **Pigment-dispersed color-filter composition**
Farbfilterzusammensetzung enthaltend dispergiertes Pigment
Composition contenant un pigment sous forme dispersée pour filtre couleur

(30) Priority: 27.03.1992 JP 10015592
(43) Date of publication of application: 06.10.1993
(73) Proprietor: JSR Corporation, Tokyo 104-0045 (JP)
(72) Inventor: Tajima, Yusuke, Japan Synthetic Rubber Co., Ltd., Yokohama-shi, Kanagawa 227 (JP); Bessho, Nobuo, Japan Synthetic Rubber Co., Ltd., Yokohama-shi, Kanagawa 227 (JP); Takinishi, Fumitaka, Foresuto Manshon 205, 21-6, Yokohama-shi, Kanagawa 225 (JP); Yokoyama, Yasuaki, Yokkaichi-shi, Mie 510-12 (JP); Masuko, Hideaki, Japan Synthetic Rubber Co., Ltd., Yokohama-shi, Kanagawa 227 (JP)
(74) Representative: Clifford, Frederick Alan

(56) References cited:
- EP-A- 0 076 028
- EP-A- 0 157 374
- EP-A- 0 480 335
- US-A- 4 902 726
- US-A- 5 096 801

## Description

### Detailed Description of the Invention

The present invention relates to a pigment-dispersed composition for a color-filter (to be referred to as "pigment-dispersed color-filter composition" hereinafter). More specifically, it relates to a pigment-dispersed color-filter composition useful for the production of color filters of a liquid crystal display and a charge coupled device.

For producing a color filter of a liquid display, a dyeing method, a printing method and an electrodeposition method are known. In recent years, a photolithographic method using a pigment-dispersed photosensitive composition is particularly attracting attention in terms of color purity, dimensional accuracy and process resistance ("Color Liquid Crystal Display" page 173, edited by Shunsuke Kobayashi, published by Sangyotosho, 1990).

However, the photolithographic method using a pigment-dispersed photosensitive composition having a variety of advantages is still required to have further improved performances for stably producing highly accurate and fine color filters. That is, a highly accurate and fine pixel is liable to peel off a substrate in a development step when a colored pixel of a color filter is formed by applying a pigment-dispersed photosensitive composition to the substrate, exposing the coating and developing it, and the color filter is thus liable to have a deficiency. On the other hand, when an attempt is made to improve the adhesion of a highly accurate and fine pixel to a substrate, the solubility of a non-pixel portion which should be dissolved away in a developer solution tends to decrease, and a so-called surface soiling and resin-remaining are liable to occur. In this case, it is general practice to apply a physical stimulus by rubbing the coating with a soft substance such as sponge or the like for removing the surface soiling and remaining resin. However, this practice is undesirable, since it involves roughening and occurrence of dust on the color filter surface, which ends up in a decrease in the yields of color filters.

When a color filter is produced from a radiation-sensitive composition, it is conventionally produced as follows. A light shielding layer in a desired pattern is formed on a glass substrate on which an SiO₂ film or the like has been formed to prevent the elution of sodium ion. A radiation-sensitive composition is spin-coated on the light shielding layer to form a coating, and the coating is heated (prebaked) and dried. The so-prepared dried coating (to be sometimes referred to as "dry coating" hereinafter) is exposed and developed to form a pixel of each color.

In the so-obtained dry coating formed on the substrate, the thickness of its central portion and the thickness of its marginal portion sometimes differs by 0.2 µm or more, and striation (streaks) sometimes occurs. It is therefore difficult to produce a dry coating having a uniform thickness. Further, an unevenness having a depth of approximately 300 to 500 Å is sometimes formed on the dry coating surface, and the dry coating surface is inferior in surface smoothness. When the surface of the coating formed by spin coating has a nonuniform thickness or fine unevenness, a color filter obtained by developing the dry coating has inferior transparency.

For this reason, in forming a color filter on a substrate surface, it is therefore desired to develop a radiation-sensitive composition for a color filter, which is capable of forming a dry coating having a uniform thickness and having an excellently smooth surface.

When a conventional color filter is produced from a radiation-sensitive composition, a coating of the composition is developed with an alkaline aqueous solution. In this case, an undissolved substance from the radiation-sensitive composition sometimes remains on a non-pixel portion of the substrate. When an undissolved substance from the radiation-sensitive composition remains on the non-pixel portion of the substrate, the color filter shows a decline in transmittance or a decrease in contrast. When a color filter is produced, generally, pixels of three colors are consecutively produced by consecutively forming coatings of radiation-sensitive compositions each of which has a hue of red, blue or green. However, when an undissolved substance of the radiation-sensitive composition for forming a pixel of one of the colors remains on the substrate, a pixel of other color subsequently formed on the substrate where the undissolved substance remains is inferior in adhesion to the substrate and hence, it may peel off. The so-remaining undissolved radiation-sensitive composition on a non-pixel portion of the substrate surface is one of the reasons for decreasing the yields of color filters.

It is therefore an object of the present invention to provide a novel pigment-dispersed color-filter composition.

It is another object of the present invention to provide a novel pigment-dispersed color-filter composition which gives pixels having excellent adhesion to a substrate and is free of surface soiling and a remaining composition in development.

It is further another object of the present invention to provide a pigment-dispersed color-filter composition which gives a color filter having little difference in thickness between its central portion and its marginal portion and having excellent surface smoothness.

Further, it is another object of the present invention to provide a pigment-dispersed color-filter composition which is capable of uniformly forming pixels having excellent adhesion to a substrate without leaving an undissolved substance of the composition on a non-pixel portion when a color filter is produced.

It is still further another object of the present invention to provide a novel pigment-dispersed color-filter composition useful for producing a color filter for a liquid crystal display and a charge coupled device.

Other objects and advantages of the present invention will be apparent from the following description.

The present invention provides a pigment-dispersed color-filter composition comprising an admixture of:
(A) an alkali-soluble block copolymer composed of a block having an acid group and a block having no acid group;
(B) a radiation-sensitive compound,
(C) a pigment,
(D) an organic medium, and
(E) an aliphatic or aromatic dicarboxylic acid having a molecular weight of 1000 or less.

The composition of the invention is free of a remaining undissolved substance of this composition on a non-pixel portion on a substrate when a color filter is formed, and thus gives a color filter in which color pixels having excellent adhesion to a substrate are evenly and uniformly formed on the substrate.

The composition of the present invention is a radiation-sensitive composition for forming a color filter, and can form a color filter without causing a remaining of an undissolved substance on a non-pixel portion on a substrate surface in development.

The color-filter radiation-sensitive composition of the present invention is used for producing a color filter by forming a color pixel on a substrate, preferably on a substrate having a light shielding layer pattern thereon, by a photolithographic method. When a pixel is formed from the color-filter radiation-sensitive composition of the present invention, no undissolved substance of the color-filter radiation-sensitive composition remains on a non-pixel portion, and the so-formed pixel, i.e., color filter is excellent in adhesion to the substrate or the light shielding layer pattern.

The pixel formed from the composition of the present invention does not at all peel off a substrate. Further, the so-formed color filter is excellent in transmittance and contrast, and such color filters can be produced from the composition of the present invention at high yields.

In the present invention, when pixels are formed from the color-filter radiation-sensitive composition, it is preferred to use an alkaline solution of sodium carbonate, sodium hydroxide, potassium hydroxide or tetramethylammonium hydroxide as a developer solution.

The block having an acid group is composed of a homopolymer formed from at least one monomer having at least one acid group such as an ethylenically unsaturated carboxylic acid (e.g. monocarboxylic acid or dicarboxylic acid) and ethylenically unsaturated sulfonic acid, a copolymer of these or a copolymer formed from the above monomer having an acid group and a monomer having no acid group and being copolymerizable with the above monomer.

In view of ease in controlling the polymerization degree, preferred as the block having an acid group is a homopolymer of an ethylenically unsaturated carboxylic acid or a copolymer formed from an ethylenically unsaturated carboxylic acid and a monomer having no acid group and being copolymerizable therewith.

The ethylenically unsaturated carboxylic acid preferably includes acrylic acid, methacrylic acid, crotonic acid, itaconic acid, maleic acid, fumaric acid, monomethyl maleate and monomethyl fumarate.

The ethylenically unsaturated sulfonic acid includes isoprenesulfonic acid and styrenesulfonic acid.

The monomer having no acid group and being copolymerizable with the above monomer includes aromatic vinyl compounds such as styrene, α-methylstyrene and vinyltoluene; ethylenically unsaturated carboxylic acid esters such as methyl (meth)acrylate, ethyl (meth)acrylate, butyl (meth)acrylate, 2-hydroxyethyl (meth)acrylate and benzyl (meth)acrylate; carboxylic acid vinyl esters such as vinyl acetate and vinyl propionate; vinyl cyanides such as (meth)acrylonitrile and α-chloroacrylonitrile; and aliphatic conjugated dienes such as 1,3-butadiene and isoprene.

The block having no acid group is formed of a polymer or copolymer composed from one of, or a plurality of, the above monomers such as aromatic vinyl compounds, ethylenically unsaturated alkyl carboxylic acid esters, vinyl carboxylic acid esters, vinyl cyanides and aliphatic conjugated dienes; ethylenically unsaturated carboxylic acid aminoalkyl esters such as aminoethyl acrylate; unsaturated aliphatic glycidyl esters such as glycidyl (meth)acrylate; macromonomers having a terminal (meth)acryloyl group such as polystyrene having a terminal (meth)acryloyl group; polymethyl (meth)acrylate having a terminal (meth)acryloyl group, polybutyl (meth)acrylate having a terminal (meth)acryloyl group and polysilicone having a terminal (meth)acryloyl group.

Of polymers or copolymers formed from the above monomers, preferred is a copolymer formed from a macromonomer containing polystyrene, polymethyl (meth)acrylate, polybutyl (meth)acrylate or polysilicone.

Specific examples of the above binder polymer (A') indude a benzyl methacrylate/methacrylic acid/styrene copolymer, a methyl methacrylate/methacrylic acid/styrene copolymer, a benzyl methacrylate/methacrylic acid/polystyrene macromonomer copolymer and a methyl methacrylate/methacrylic acid/polystyrene macromonomer copolymer.

The block copolymer can be produced by one of well known polymerization methods such as a living polymerization method, a method in which different blocks are bonded by a functional group reaction and a method using the macromonomer ["Kobunshi Gosei" (Polymer Synthesis), Essence of Polymer and Topics 2, Chapter 12, Junji Furukawa, published by Kagaku Dojin 1986]. When the macromonomer is used, advantageously, the intended block copolymer can be obtained by a simple radical polymerization method.

When the block copolymer is produced, the amount of the monomer having an acid group is preferably 15 to 50% by weight based on the total amount of the monomers. When this amount is less than 15% by weight, the solubility of the block copolymer in an alkali developer solution is insufficient, and a surface soiling and a resin-remaining are liable to occur on a non-pixel portion. When it exceeds 50% by weight, the solubility of the block copolymer in an alkali developer solution is too high, and pixels are liable to peel off a substrate. The amount of the monomer having an acid group is particularly preferably 20 to 40% by weight.

Concerning the molecular weight of the block copolymer, the weight average molecular weight of the block copolymer as a polystyrene measured by gel permeation chromatography (to be abbreviated as GPC hereinafter) using tetrahydrofuran (THF) as a carrier is preferably 10,000 to 500,000, particularly preferably 20,000 to 300,000.

When the above molecular weight of the block copolymer exceeds 500,000, a scumming is liable to occur around developed pixels, a pattern edge is liable to show insufficient sharpness, and a surface soiling and resin-remaining are liable to occur on a non-pixel portion. When the molecular weight of the block copolymer is less than 10,000, the solubility of the block copolymer in an alkali developer solution is too high under optimum development condition, and the time span for the development is small (for example about 20 to 40 seconds), and the so-called development time margin is liable to decrease.

The radiation-sensitive compound (B) can be selected, for example, from (1) a compound whose molecule is decomposed under irradiation with radiation to free an active compound, generate a chain reaction of unsaturated double bonds and form a three-dimensionally crosslinked compound and (2) a compound whose molecule is decomposed under irradiation with radiation to bond to a C-C bond or a C-H bond by an insertion reaction and form a three-dimensionally crosslinked structure.

The above (1) compound is selected from those compounds which generate radicals, carbene or nitrene, i.e., a photopolymerization initiator and a compound which has polyvalent unsaturated double bonds and is polymerized under irradiation with radiation, i.e., a photopolymerizable monomer and oligomer.

Examples of the photopolymerization initiator include a carbonium compound, an azo or azide compound, an organic sulfur compound, peroxide and a trihalomethane compound.

Specific examples of the carbonium compound include diacetyl, benzyl, benzoin, 2-hydroxy-2-methyl-1-phenylpropan-1-one, 1-(4-isopropylphenyl)-2-hydroxy-2-methylpropan-1-one, 4-(2-hydroxyethoxy)phenyl-2-(hydroxy-2-propyl)ketone, 1-hydroxycyclohexylketone, 2,2-dimethoxy-2-phenylacetophenone, 2-methyl[4-(methylthio)phenyl]-2-morpholino-1-propan-1-one, 2-benzyl-2-dimethylamino-1-(4-morpholinophenyl)-butan-1-one, benzophenone, 4,4'-bis(dimethylamino)benzophenone, 4,4'-bis(diethylamino)benzophenone, 2,4-diethylthioxanthone and 3,3-dimethyl-4-methoxybenzophenone.

Specific examples of the azo or azide compound include azoisobutyronitrile, diazonium, 4-azidobenzaldehyde, 4-azidoacetophenone, 4-azidobenzalacetophenone, 4-azidobenzalacetone, azidopyrene, 4-diazodiphenylamine, 4-diazo-4'-methoxydiphenylamine and 4-diazo-3'-methoxydiphenylamine.

Specific examples of the organic sulfur compound include mercaptan disulfide.

Specific examples of the peroxide include diethyl ether peroxide.

Specific examples of the trihalomethane include 1,3-bis(trichloromethyl)-5-(2'-chlorophenyl)-5-triazine and 1,3-bis(trichloromethyl)-5-(4'-methoxyphenyl)-s-triazine.

Examples of the photopolymerizable monomer or oligomer include polyacryloyl compounds such as trimethylolpropane triacrylate, pentaerythritol triacrylate, trisacryloyloxyethyl phosphate, pentaerythritol tetraacrylate, dipentaerythritol pentaacrylate and dipentaerythritol hexaacrylate; a condensate of 4-azidobenzaldehyde and polyvinyl alcohol, a condensate of 4-azidobenzaldehyde and a phenol novolak resin, and a polymer or copolymer of 4-acryloylphenylcinnamoyl ester.

The above (2) compound is selected from those compounds having at least two functional groups which generate carbene or nitrene under irradiation with radiation, i.e., photo-crosslinking agents.

Examples of the photo-crosslinking agents include diazidochalcone, 2,6-bis(4'-azidobenzal)cyclohexanone, 2,6-bis(4'-azidobenzal)-4-methylcyclohexanone, 1,3-bis(4'-azidobenzal)-2-propane, 1,3-bis(4'-azidocinnamylidene)-2-propanone, 4,4'-diazidostilbene and ammonium bichromate.

Of the above radiation-sensitive compounds, it is preferred to use a compound which generates radicals under irradiation with radiation as a photopolymerization initiator and a polyacryloyl compound as a photopolymerizable monomer or oligomer.

For example, 2-methyl[4-(methylthio)phenyl]2-morpholino-1-propan-1-one or 2-benzyl-2-dimethylamino-1-(4-morpholinophenyl)-butan-1-one is used as a photopolymerization initiator, and pentaerythritol triacrylate or dipentaerythritol hexaacrylate is used as a photopolymerizable monomer or oligomer. In this case, the amount of the photopolymerization initiator per 100 parts by weight of the photopolymerizable monomer or oligomer is 0.01 to 200 parts by weight, preferably 1 to 120 parts by weight.

The radiation-sensitive compound may be used in any amount as far as the first composition can form a coating having an adhesion under irradiation with radiation, and yet the amount of the radiation-sensitive compound per 100 parts by weight of the alkali-soluble block copolymer (A) is preferably 5 to 500 parts by weight, more preferably 20 to 200 parts by weight. When this amount is less than 5 parts by weight, the clearness of pixels is liable to be insufficient. When it exceeds 500 parts by weight, a resin is liable to remain on a non-pixel portion.

The pigment (C) is selected from both organic pigments and inorganic pigments.

As organic pigments, preferred are dyes and pigments which are insoluble in water or an organic solvent. Specific examples of the organic pigments are described in chapter "Pigment" under "Color Index" (published by The Society of Dyers and Colourists).

As inorganic pigments, preferred are metal-containing compounds such as metal oxides and metal complex salts. Specific examples of the inorganic pigments include oxides of iron, cobalt, aluminum, cadmium, lead, copper, titanium, magnesium, chromium, zinc and antimony and composite oxides of these.

Specifically, the pigment (C) includes the following.
C. I. Pigment Yellow 24
C. I. Pigment Yellow 31
C. I. Pigment Yellow 53
C. I. Pigment Yellow 83
C. I. Pigment Orange 43
C. I. Pigment Red 105
C. I. Pigment Red 149
C. I. Pigment Red 176
C. I. Pigment Red 177
C. I. Pigment Violet 14
C. I. Pigment Violet 29
C. I. Pigment Blue 15
C. I. Pigment Blue 15:3
C. I. Pigment Blue 22
C. I. Pigment Blue 28
C. I. Pigment Green 15
C. I. Pigment Green 25
C. I. Pigment Green 36
C. I. Pigment Brown 28
C. I. Pigment Black 1
C. I. Pigment Black 7

The amount of the pigment (C) per 100 parts by weight of the alkali-soluble block copolymer (A) is 10 to 1,000 parts by weight, preferably 20 to 500 parts by weight. When this amount is less than 10 parts by weight, the color density in a pixel portion is liable to be insufficient. When it exceeds 1,000 parts by weight, a surface soiling and a resin-remaining are liable to occur on a non-pixel portion.

The first composition of the present invention may further contain other additives as required in addition to the above components (A), (B) and (C).

The above "other additives" include a filler, other polymer compound, a surfactant, an adhesion promoter, an antioxidant, an ultraviolet light absorber, an aggregation preventer and a sensitizer.

Specific examples of the other additives include fillers such as glass and alumina; polymer compounds such as polyvinyl alcohol, polyacrylic acid, polyethylene glycol monoalkyl ether and polyfluoroalkyl acrylate; nonionic, cationic and anionic surfactants; adhesion promoters such as vinyltrimethoxysilane, vinyltriethoxysilane, vinyltris(2-methoxyethoxy)silane, N-(2-aminoethyl)3-aminopropylmethyldimethoxysilane, N-(2-aminoethyl)3-aminopropyltrimethoxysilane, 3-aminopropyltriethoxysilane, 3-glycidoxypropyltrimethoxysilane, 3-glycidoxypropylmethyldimethoxysilane, 2-(3,4-epoxycyclohexyl)ethyltrimethoxysilane, 3-chloropropylmethyldimethoxysilane, 3-chloropropyltrimethoxysilane, 3-methacryloxypropyltrimethoxysilane and 3-mercaptopropyltrimethoxysilane; antioxidants such as 2,2-thiobis(4-methyl-6-t-butylphenol) and 2,6-di-t-butylphenol; ultraviolet light absorbers such as 2-(3-t-butyl-5-methyl-2-hydroxyphenyl)-5-chlorobenzotriazole and alkoxybenzophenone; aggregation preventers such as sodium polyacrylate and sodium polymethacrylate; and sensitizers such as benzophenone, 4,4'-bis(dimethylamino)benzophenone, 4,4'-bis(diethylamino)benzophenone and nitropyrene.

The solvent (organic medium D) for dissolving the first composition of the present invention is preferably selected from alcohols such as methyl alcohol, ethyl alcohol, n-propyl alcohol and i-propyl alcohol; cellosolves such as methyl cellosolve and ethyl cellosolve; carbitol type solvents such as diethylene glycol methyl ether and diethylene glycol ethyl ether; esters such as ethyl acetate, butyl acetate, methyl methoxypropionate, ethyl ethoxypropionate and ethyl lactate; ketones such as acetone, methyl isobutyl ketone and cyclohexanone; cellosolve acetates such as methylcellosolve acetate and ethylcellosolve acetate; carbitol acetate solvents such as diethylene glycol methyl acetate and diethylene glycol ethyl acetate; ethers such as diethyl ether, ethylene glycol dimethyl ether, diethylene glycol diethyl ether (diglyme) and tetrahydrofuran; aprotic amide solvents such as N,N-dimethylformamide, N,N-dimethylacetamide and N-methylpyrrolidone; lactones such as γ-butyrolactone, aromatic hydrocarbons such as benzene, toluene, xylene and naphthalene; and saturated hydrocarbons such as n-heptane, n-hexane and n-octane.

The first composition of the present invention can be prepared by mixing and dispersing the above components (A), (B) and (C) and optionally other additive(s) in the presence of the solvent by means of a ball mill, a pebble mill, a shaker, a homogenizer, a three-roll mill or a sand mill.

The substrate used for forming a color filter from the so-prepared first composition of the present invention includes soda glass, Pyrex glass, quartz glass and products prepared by forming a transparent electrically conductive coating on these glasses, which are used in a liquid crystal device, and a photoelectric transfer device substrate used in a solid camera device such as a silicon substrate.

The photopolymerization initiator, photopolymerizable monomer, photopolymerizable oligomer and photo-crosslinking agent, all of which are described above, may be used alone or in combination, and particularly, it is preferred to use the photopolymerization initiator and either the photopolymerizable monomer or photopolymerizable oligomer in combination.

When the photopolymerization initiator and either the photopolymerizable monomer or photopolymerizable oligomer is used in combination, the amount of the photopolymerization initiator per 100 parts by weight of the photopolymerizable monomer or oligomer is 0.01 to 200 parts by weight, preferably 1 to 120 parts by weight.

The organic medium (D) refers to an ester, an ether and a ketone which have a boiling point, measured at atmospheric pressure, of 100 to 200°C and a vapor pressure, measured at 20°C, of 0.05 to 10 mmHg.

The above ester, ether and ketone specifically indude the following:
Saturated aliphatic monocarboxylic acid alkyl esters such as n-butyl acetate and isobutyl acetate;
Lactic acid esters such as methyl lactate and ethyl lactate;
Oxyacetic acid alkyl esters such as methyl oxyacetate, ethyl oxyacetate and butyl oxyacetate;
Alkoxyacetic acid alkyl esters such as methyl methoxyacetate, ethyl methoxyacetate, butyl methoxyacetate, methyl ethoxyacetate and ethyl ethoxyacetate;
3-Oxypropionic acid alkyl esters such as methyl 3-oxypropionate and ethyl 3-oxypropionate;
3-Alkoxypropionic acid alkyl esters such as methyl 3-methoxypropionate, ethyl 3-methoxypropionate, methyl 3-ethoxypropionate and ethyl 3-ethoxypropionate;
2-Oxypropionic acid alkyl esters such as methyl 2-oxypropionate, ethyl 2-oxypropionate and propyl 2-oxypropionate;
2-Alkoxypropionic acid alkyl esters such as methyl 2-methoxypropionate, ethyl 2-methoxypropionate, propyl 2-methoxypropionate, methyl 2-ethoxypropionate and ethyl 2-ethoxypropionate;
2-Oxy-2-methylropionic acid alkyl esters such as methyl 2-oxy-2-methylpropionate and ethyl 2-oxy-2-methylpropionate;
Monooxymonocarboxylic acid alkyl esters such as methyl 2-methoxy-2-methylpropionate and ethyl 2-ethoxy-2-methylpropionate;
Ketonic acid esters such as ethyl pyruvate;
Cellosolve acetates such as methylcellosolve acetate, ethylcellosolve acetate and diethylcellosolve acetate;
Ethers such as dichloroethyl ether, n-butyl ether, diisoamyl ether and methyl phenyl ether;
Carbitols such as methyl ethyl carbitol, diethyl carbitol, diethylene glycol methyl ethyl ether, diethylene glycol dimethyl ether and diethylene glycol diethyl ether;

Ketones such as cyclohexanone, methyl-n-propyl ketone, methyl-n-butyl ketone, methyl-n-amyl ketone and 2-heptanone.

The above organic media may be used alone or in combination.

The above ester, ether or ketone contained in the medium (D) has a boiling point of 100 to 200° C as described above, and preferred are organic media having a boiling point of 130 to 190° C.

The above ester, ether or ketone has a vapor pressure of 0.05 to 10.0 mmHg, and preferred are organic media having a vapor pressure of 0.1 to 5.0 mmHg.

Specific examples of the organic solvent preferably include ethyl lactate, methyl 3-methoxypropionate, ethyl 3-ethoxypropionate, ethyl 2-ethoxypropionate, methylcellosolve acetate, ethylcellosolve acetate, diethylene glycol dimethyl ether, diethylene glycol diethyl ether and propylene glycol monomethyl ether acetate.

The present invention can be prepared by dissolving or dispersing the above components (A), (B), (C) and (D) and optionally other component(s).

When such a preferred composition is used, the organic solvent is sufficiently evaporated in a prebaking step, and there is no case where a large amount of the organic solvent remains in the dry coating. Therefore, the dry coating surface does not at all have the property of adhesion and does not cause sticking. Further, since no organic solvent remains in the dry coating in a large amount, the dry coating does not peel off the substrate, nor does the heat resistance decrease.

Further, the preferred composition can be evenly and uniformly applied onto a glass substrate with a spin coater. Therefore, the composition can form a dry coating having a uniform thickness and having an excellently smooth surface without causing striation. Moreover, the so-formed dry coating has excellent adhesion to the substrate.

The above dry coating is developed with an alkali to give a color filter having excellent transparency.

When the preferred composition of the present invention is used, color filters having excellent transparency can be produced at high yields.

For forming pixels from the radiation-sensitive color-filter composition in the present invention, it is preferred to use an alkaline solution of at least one member selected from inorganic alkalis such as sodium carbonate, potassium hydroxide and potassium carbonate and organic alkalis such as tetramethylammonium hydroxide.

Of organic solvents (D), preferred are cellosolve acetates such as methoxyethyl acetate, ethoxyethyl acetate and ethylcellosolve acetate, carbitol acetate type solvents such as methoxyethoxyethyl acetate and ethoxyethoxyethyl acetate, ethers such as ethylene glycol dimethyl ether, diethylene glycol diethyl ether and propylene glycol diethyl ether and esters such as methyl methoxypropionate, ethyl ethoxypropionate and ethyl lactate.

The amount of the organic medium (D) per 100 parts by weight of the binder polymer (A') is 100 to 10,000 parts by weight, preferably 500 to 5,000 parts by weight.

The organic aromatic or aliphatic dicarboxylic acid (E) used in the invention has a molecular weight of 1,000 or less.

Specific examples of the aliphatic dicarboxylic acids indude oxalic acid, malonic acid, succinic acid, glutaric acid, adipic acid, pimelic acid, suberic acid, azelaic acid, sebacic acid, brassylic acid, methylmalonic acid, ethylmalonic acid, dimethylmalonic acid, methylsuccinic acid, tetramethylsuccinic acid, cyclohexanedicarboxylic acid, itaconic acid, citraconic acid, maleic acid and fumaric acid; and tricarboxylic acids such as tricarballylic acid, aconitic acid and camphoronic acid.

Examples of the aromatic dicarboxylic acids include carboxylic acids in which a carboxyl group directly bonds to a phenyl group and carboxylic acids in which a carboxyl group is bond to a phenol group through a carbon bond.

Specific examples of the above phenyl group-containing dicarboxylic acids include phthalic acid, isophthalic acid, terephthalic acid, mellophanic acid; hydratropic acid, phenylsuccinic acid, and cinnamylideneacetic acid.

Of the above acids, preferred are malonic acid, citraconic acid, itaconic acid, mesaconic acid, fumaric acid and phthalic acid.

The above organic dicarboxylic acids may be used alone or in combination.

The content of the above organic dicarboxylic acid (E) in the third composition is preferably 0.001 to 10% by weight, more preferably 0.01 to 1% by weight.

When the content of the organic dicarboxylic acid (E) is less than 0.001% by weight, it may be impossible to prevent the remaining of an undissolved substance on a non-pixel portion on a substrate. When it exceeds 10% by weight, the adhesion between pixels and the substrate may decrease.

The present invention will be further detailed hereinafter by reference to Examples, in which "%" stands for "% by weight" and "part" stands for "parts by weight".

### Example 1

A light shielding layer having a desired form was formed on a soda glass substrate surface on which an SiO₂ film had been formed for preventing sodium ion elution. Then, a color-filter radiation-sensitive composition shown in Table 1 was coated on the light shielding layer with a spin coater to form a desired coating thickness, and the so-formed coating was dried at 80° C for 10 minutes, and then cooled. Then, the so-formed color filter layer was exposed to ultraviolet light at 400 mj/cm² from a high pressure mercury lamp through a photomask, and developed by immersing the substrate in an aqueous solution containing 0.05 % of sodium carbonate to give red pixels having a size of 20 µm x 20 µm each.

**Table 1**

| | Compound | part |
|---|---|---|
| Pigment | C.I. Pigment Red 177 | 90 |
| | | |
| Binder | Benzyl methacrylate/methacrylic acid/styrene copolymer (compositional weight ratio 65/25/10, average molecular weight Mw 40,000) | 50 |
| | | |
| Radiation-sensitive compound | Trimethylolpropane triacrylate (M-309, supplied by Toagosei Chemical Industries Co., Inc.) | 40 |
| | | |
| | 1-Hydroxycyclohexyl phenyl ketone (I-184, supplied by Japan Ciba Geigy) | 24 |
| | | |
| Solvent | Ethylcellosolve acetate | 790 |
| | | |
| Organic acid | Oxalic acid | 6 |

The so-formed color pixels gave a color filter in which no undissolved substance remained in a non-pixel portion on the substrate.

The same color-filter radiation-sensitive composition as the above color-filter radiation-sensitive composition was allowed to stand at room temperature for 3 days, and then red pixels were formed in the same manner as above and developed by immersing the substrate in an aqueous solution containing 0.05 % of sodium carbonate to give a color filter in which no undissolved substance remained in a non-pixel portion on the substrate.

### Comparative Example 1

Red pixels were formed in the same manner as in Example 15 except that the color-filter radiation-sensitive composition was replaced with a color-filter radiation-sensitive composition shown in Table 2.

**Table 2.**

| | Compound | part |
|---|---|---|
| Pigment | C.I. Pigment Red 177 | 90 |
| | | |
| Binder | Benzyl methacrylate/methacrylic acid/styrene copolymer (compositional weight ratio 65/25/10, average molecular weight Mw 40,000) | 50 |
| | | |
| Radiation-sensitive compound | Trimethylolpropane triacrylate (M-309, supplied by Toagosei Chemical Industries Co., Inc.) | 40 |
| | | |
| | 1-Hydroxycyclohexyl phenyl ketone (I-184, supplied by Japan Ciba Geigy) | 20 |
| | | |
| Solvent | Ethylcellosolve acetate | 796 |

In the above-formed color pixels, an undissolved substance was formed in a non-pixel portion on the substrate.

When the concentration of sodium carbonate was increased to 0.5 %, the undissolved portion decreased in amount, but the formed pixels partly peeled off and the sharpness of the pixel edges declined.

### Example 2

Blue pixels were formed in the same manner as in Example 15 except that the color-filter radiation-sensitive composition was replaced with a color-filter radiation-sensitive composition shown in Table 3.

**Table 3.**

| | Compound | part |
|---|---|---|
| Pigment | C.I. Pigment Blue 15 | 90 |
| | | |
| Binder | Benzyl methacrylate/methacrylic acid/styrene copolymer (compositional weight ratio 65/25/10, average molecular weight Mw 40,000) | 50 |
| | | |
| Radiation-sensitive compound | Dipentaerythritol pentaacrylate (M-400, supplied by Toagosei Chemical Industries Co., Inc.) | 40 |
| | | |
| | 2,2-Dimethoxy-2-phenylacetophenone (I-651 supplied by Japan Ciba Geigy) | 20 |
| | | |
| Solvent | Diethylene glycol dimethyl ether | 790 |
| | | |
| Organic carboxylic acid | Itaconic acid | 6 |

The above-formed color pixels gave a color filter in which no undissolved substance remained in a non-pixel portion on the substrate.

Further, after the same color-filter radiation-sensitive composition as the above color-filter radiation-sensitive composition was allowed to stand at room temperature for 3 days in the same manner as in Example 1, it gave a color filter in which no undissolved substance remained in a non-pixel portion on the substrate.

### Comparative Example 2

An attempt was made to form blue pixels in the same manner as in Example 15 except that the color-filter radiation-sensitive composition was replaced with a color-filter radiation-sensitive composition shown in Table 4.

**Table 4**

| | Compound | part |
|---|---|---|
| Pigment | C.I. Pigment Blue 15 | 90 |
| | | |
| Binder | Benzyl methacrylate/methacrylic acid/styrene copolymer (compositional weight ratio 65/25/10, average molecular weight Mw 40,000) | 50 |
| | | |
| Radiation-sensitive compound | Dipentaerythritol pentaacrylate (M-400, supplied by Toagosei Chemical Industries Co., Inc.) | 40 |
| | | |
| | 2.2-Dimethoxy-2-phenylacetophenone (I-651 supplied by Japan Ciba Geigy) | 24 |
| | | |
| Solvent | Diethylene glycol dimethyl ether | 646 |
| | | |
| Organic carboxylic acid | Itaconic acid | 450 |

The above color-filter radiation-sensitive composition contained a large amount, as large as 15 % by weight, of itaconic acid (organic carboxylic acid). Therefore, when a dry coating was developed with a sodium carbonate aqueous solution, both the pixel portion and the non-pixel portion were dissolved away in the sodium carbonate aqueous solution, and no pixels were formed.

Even when the concentration of sodium carbonate in an aqueous solution was decreased to 0.001 %, there was no change in the result.

### Example 3

Green pixels were formed in the same manner as in Example 1 except that the color-filter radiation-sensitive composition was replaced with a color-filter radiation-sensitive composition shown in Table 5

**Table 5**

| | Compound | part |
|---|---|---|
| Pigment | C.I. Pigment Green 7 | 90 |
| | | |
| Binder | Benzyl methacrylate/methacrylic acid/styrene copolymer (compositional weight ratio 65/25/10, average molecular weight Mw 40,000) | 50 |
| | | |
| Radiation-sensitive compound | Trimethylolpropane triacrylate (Biscoat 295, supplied by Osaka Organic Chemical Industry Ltd) | 40 |
| | | |
| | 2,2-Dimethoxy-2-phenylacetophenone (I-651 supplied by Japan Ciba Geigy) | 24 |
| | | |
| Solvent | Diethylene glycol dimethyl ether | 793 |
| | | |
| Organic carboxylic acid | Phthalic acid | 3 |

The above-formed color pixels gave a color filter in which no undissolved substance remained in a non-pixel portion on the substrate.

Further, after the same color-filter radiation-sensitive composition as the above color-filter radiation-sensitive composition was allowed to stand at room temperature for 3 days in the same manner as in Example 1 , it gave a color filter in which no undissolved substance remained in a non-pixel portion on the substrate.

### Example 4

Red pixels were formed in the same manner as in Example 1 except that the color-filter radiation-sensitive composition was replaced with a color-filter radiation-sensitive composition shown in Table 6.

**Table 6**

| | Compound | part |
|---|---|---|
| Pigment | C.I. Pigment Red 177 | 90 |
| | | |
| Binder | Methacrylate/methacrylic acid/styrene copolymer (compositional weight ratio 65/25/10, average molecular weight Mw 40,000) | 50 |
| | | |
| Radiation-sensitive compound | Trimethylolpropane triacrylate (M-309, supplied by Toagosei Chemical Industries Co., Inc.) | 40 |
| | | |
| | 1-Hydroxycyclohexyl phenyl ketone (I-184 supplied by Japan Ciba Geigy) | 24 |
| | | |
| Solvent | Ethylcellosolve acetate | 790 |
| | | |
| Organic carboxylic acid | Malonic acid | 6 |

The above-formed color pixels gave a color filter in which no undissolved substance remained in a non-pixel portion on the substrate.

Further, after the same color-filter radiation-sensitive composition as the above color-filter radiation-sensitive composition was allowed to stand at room temperature for 3 days in the same manner as in Example 1 , it gave a color filter in which no undissolved substance remained in a non-pixel portion on the substrate.

### Example 5

Green pixels were formed in the same manner as in Example 1 except that the color-filter radiation-sensitive composition was replaced with a color-filter radiation-sensitive composition shown in Table 7.

**Table 7**

| | Compound | part |
|---|---|---|
| Pigment | C.I. Pigment Green 7 | 90 |
| | | |
| Binder | Benzyl methacrylate/methacrylic acid/polystyrene macromonomer (compositional weight ratio 65/25/10, average molecular weight Mw 40,000) | 50 |
| | | |
| Radiation-sensitive compound | Trimethylolpropane triacrylate (Biscoat 295, supplied by Osaka Organic Chemical Industry Ltd) | 40 |
| | | |
| | 2-Benzyl-2-dimethylamino-1-(4-morpholinophenyl)-butan-1-one (I-369 supplied by Japan Ciba Geigy) | 24 |
| | | |
| Solvent | Diethylene glycol dimethyl ether | 790 |
| | | |
| Organic carboxylic acid | Citraconic acid | 6 |

The above-formed color pixels gave a color filter in which no undissolved substance remained in a non-pixel portion on the substrate.

Further, after the same color-filter radiation-sensitive composition as the above color-filter radiation-sensitive composition was allowed to stand at room temperature for 3 days in the same manner as in Example 1 , it gave a color filter in which no undissolved substance remained in a non-pixel portion on the substrate.

### Example 6

Green pixels were formed in the same manner as in Example 1 except that the color-filter radiation-sensitive composition was replaced with a color-filter radiation-sensitive composition shown in Table 8.

**Table 8**

| | Compound | part |
|---|---|---|
| Pigment | C.I. Pigment Green 7 | 90 |
| | | |
| Binder | Methacrylate/methacrylic acid/polystyrene macromonomer (compositional weight ratio 65/25/10, average molecular weight Mw 40,000) | 50 |
| | | |
| Radiation-sensitive compound | Trimethylolpropane triacrylate (Biscoat 295, supplied by Osaka Organic Chemical Industry | 40 Ltd) |
| | | |
| | 2-Benzyl-2-dimethylamino-1-(4-morpholinophenyl)-butan-1-one (I-369 supplied by Japan Ciba Geigy) | 24 |
| | | |
| Solvent | Diethylene glycol dimethyl ether | 790 |
| | | |
| Organic | Citraconic acid | 3 |
| carboxylic acid | Mesaconic acid | 3 |

The above-formed color pixels gave a color filter in which no undissolved substance remained in a non-pixel portion on the substrate.

Further, after the same color-filter radiation-sensitive composition as the above color-filter radiation-sensitive composition was allowed to stand at room temperature for 3 days in the same manner as in Example 1, it gave a color filter in which no undissolved substance remained in a non-pixel portion on the substrate.

## Claims

1. A pigment-dispersed color-filter composition comprising an admixture of:
(A) an alkali-soluble block copolymer composed of a block having an acid group and a block having no acid group;
(B) a radiation-sensitive compound,
(C) a pigment,
(D) an organic medium, and
(E) an aliphatic or aromatic dicarboxylic acid having a molecular weight of 1000 or less.

2. The composition of claim 1, wherein the radiation-sensitive compound (B) is selected from the group consisting of a polymerization initiator which generates radicals under irradiation with radiation and is selected from a carbonium compound, an azo compound, an azide compound, an organic sulfur compound, a peroxide compound and a trihalomethane compound and a photo-crosslinking agent having at least two functional groups which generate carbene or nitrene under irradiation with radiation.

3. The composition of claim 1, wherein the organic medium (D) is selected from the group consisting of ethyl lactate, methyl 3-methoxypropionate, ethyl 3-ethoxypropionate, ethyl 2-ethoxypropionate, methyl-cellosolve acetate, ethylcellosolve acetate, diethylene glycol dimethyl ether, diethylene glycol deithyl ether and propylene glycol monomethyl ether acetate.

4. The composition of claim 1, wherein the amount of the organic medium (D) per 100 parts by weight of the alkali-soluble block copolymer (A) is 100 to 10,000 parts by weight.

5. The composition of claim 1, wherein the aliphatic or aromatic dicarboxylic acid is selected from the group consisting of malonic acid, citraconic acid, itaconic acid, mesaconic acid, fumaric acid and phthalic acid,

6. The composition of claim 1, wherein the alkali-soluble block copolymer is a copolymer derived from benzyl methacrylate, methacrylic acid and polystyrene macromonomer, or a copolymer derived from methyl methacrylate, methacrylic acid and polystyrene macromonomer.

## Patentansprüche

1. Pigmentdispergierte Farbfilterzusammensetzung, umfassend eine Beimischung aus:
(A) einem alkalilöslichen Blockcopolymer, zusammengesetzt aus einem Block mit einer Säuregruppe und einem Block mit keiner Säuregruppe;
(B) einer strahlungsempfindlichen Verbindung;
(C) einem Pigment;
(D) einem organischen Medium; und
(E) einer aliphatischen oder aromatischen Dicarbonsäure mit einem Molekulargewicht von 1000 oder weniger.

2. Zusammensetzung nach Anspruch 1, wobei die strahlungsempfindliche Verbindung (B) aus der Gruppe bestehend aus einem Polymerisationsinitiator, welcher Radikale unter Bestrahlung mit Strahlung erzeugt und ausgewählt ist aus einer Carboniumverbindung, einer Azoverbindung, einer Azidverbindung, einer organischen Schwefelverbindung, einer Peroxidverbindung und einer Trihalomethanverbindung, und einem Photovernetzungsmittel mit mindestens zwei funktionellen Gruppen, welche Carben oder Nitren unter Bestrahlung mit Strahlung erzeugen, ausgewählt ist.

3. Zusammensetzung nach Anspruch 1, wobei das organische Medium (D) aus der Gruppe bestehend aus Ethyllactat, Methyl-3-Methoxypropionat, Ethyl-3-ethoxypropionat, Ethyl-2-ethoxypropionat, Methyl-Cellosolveacetat, Ethyl-cellosolveacetat, Diethylenglykoldimethylether, Diethylenglykoldiethylether und Propylenglykolmonomethyletheracetat ausgewählt ist.

4. Zusammensetzung nach Anspruch 1, wobei die Menge des organischen Mediums (D) pro 100 Gewichtsteile des alkalilöslichen Blockcopolymeren (A) 100 bis 10 000 Gewichtsteile beträgt.

5. Zusammensetzung nach Anspruch 1, wobei die aliphatische oder aromatische Dicarbonsäure aus der Gruppe bestehend aus Malonsäure, Citraconsäure, Itaconsäure, Mesaconsäure, Fumarsäure und Phthalsäure ausgewählt ist.

6. Zusammensetzung nach Anspruch 1, wobei das alkalilösliche Blockcopolymer ein Copolymer ist, das von Benzylmethacrylat, Methacrylsäure und Polystyrolmakromonomer abstammt, oder ein Copolymer, das von Methylmethacrylat, Methacrylsäure und Polystyrolmakromonomer abstammt.

## Revendications

1. Composition de filtre coloré à pigment dispersé, comprenant un mélange de:
(A) un copolymère séquencé soluble en milieu alcalin, composé d'une séquence ayant un groupe acide et d'une séquence n'ayant pas de groupe acide;
(B) un composé radio-sensible;
(C) un pigment;
(D) un milieu organique; et
(E) un acide dicarboxylique aliphatique ou aromatique ayant un poids moléculaire de 1000 ou moins.

2. Composition selon la revendication 1, dans laquelle le composé radio-sensible (B) est choisi dans le groupe constitué par un initiateur de polymérisation qui génère des radicaux sous irradiation avec une radiation et est choisi parmi un composé carbonium, un composé azoïque, un composé azide, un composé soufré organique, un composé peroxyde et un composé trihalogénométhane, et un agent de photo-réticulation ayant au moins deux groupes fonctionnels qui génèrent du carbène ou du nitrène sous irradiation avec une radiation.

3. Composition selon la revendication 1, dans laquelle le milieu organique (D) est choisi dans le groupe constitué par le lactate d'éthyle, le 3-méthoxypropionate de méthyle, le 3-éthoxypropionate d'éthyle, le 2-éthoxypropionate d'éthyle, l'acétate de méthyl-cellosolve, l'acétate d'éthyl-cellosolve, l'éther diméthylique de diéthylèneglycol, l'éther diéthylique de diéthylèneglycol et l'acétate d'éther monométhylique de propylèneglycol.

4. Composition selon la revendication 1, dans laquelle la quantité du milieu organique (D) pour 100 parties en poids du copolymère séquencé soluble en milieu alcalin (A) est de 100 à 10 000 parties en poids.

5. Composition selon la revendication 1, dans laquelle l'acide dicarboxylique aliphatique ou aromatique est choisi dans le groupe constitué par l'acide malonique, l'acide citraconique, l'acide itaconique, l'acide mésaconique, l'acide fumarique et l'acide phtalique.

6. Composition selon la revendication 1, dans laquelle le copolymère séquencé soluble en milieu alcalin est un copolymère provenant de méthacrylate de benzyle, d'acide méthacrylique et d'un macromonomère de polystyrène, ou un copolymère provenant de méthacrylate de méthyle, d'acide méthacrylique et d'un macromonomère de polystyrène.
